# EUROPEAN PATENT APPLICATION

(11) **EP 1 202 328 A2**
(43) Date of publication of application: **02.05.2002**
(21) Application number: 01125853.0
(22) Date of filing: 30.10.2001
(51) Int. Cl.: H01L 21/00

(54) **Quartz glass wafer support jig and method for producing the same**

(30) Priority: 31.10.2000 JP 2000334022
(71) Applicant: Heraeus Quarzglas GmbH & Co. KG, 63450 Hanau (DE); Shin-Etsu Quartz Products Co.,Ltd., Shinjuku-ku Tokyo 160-0023 (JP); Yamagata Shin-Etsu Quartz Co. Ltd., Tendo-shi, Yamagata 994-0065 (JP)
(72) Inventor: Saito, Makoto, Yamagata-shi, Yamagata-ken 990-0829 (JP); Konno, Toshiaki, Yamagata-shi, Yamagata-ken 990-2412 (JP)
(74) Representative: Grimm, Ekkehard, Dipl.-Phys.

(57) **Abstract**

An object of the present invention is to provide a novel wafer support jig and a process for producing the same, said wafer support jig capable of considerably suppressing the generation of particles in the wafer heat treatment process, e.g., a CVD process, during the production of semiconductors. In order to solve the problems a quartz glass wafer support jig is suggested comprising a plurality of support pillars having provided thereto a plurality of ring-shaped support plates for mounting thereon the wafers, said support plates being superposed one after another with a predetermined distance taken between the neighboring plates in the vertical direction, a quartz glass wafer support jig characterized in that it comprises said ring-shaped support plates each having its upper and lower surfaces precisely polished and each having provided with chamfered portions formed by chamfering the upper and lower edge portions of the outer and inner peripheries thereof.

## Description

The present invention relates to a wafer support jig for use in the production of semiconductors, and in particular, it relates to a quartz glass vertical-type wafer support jig comprising a plurality of support pillars having provided thereto a plurality of ring-shaped support plates for mounting thereon the wafers, said support plates each having an upper and a lower surface and being superposed one after another with a predetermined distance taken between the neighboring plates in the vertical direction. Furthermore the invention relates to a method for producing a wafer support jig.

### Related Art

In the semiconductor production process, a vertical-type wafer support jig has been employed as a quartz glass wafer support jig for use in the heat treatment process, for instance, in the CVD process, for wafers. Such a vertical-type wafer support jig - in the following referred to as "a first type" - is disclosed in JP-A-Hei 8-102486. It supports a plurality of wafers by a plurality of groove portions engraved to a plurality of pillars. A second type of wafer support jig is disclosed in Japanese utility model JP-A-Hei 6-62538. It comprises a plurality of support pillars having provided thereto a plurality of ring-shaped support plates for mounting thereon the wafers, said support plates being superposed one after another with a predetermined distance taken between the neighboring plates in the vertical direction. The second type of wafer support jigs requires higher production costs, although, they have the advantage that they can reduce the turbulence in gas flow during the heat treatment, and they can thereby implement a more favorable thin film. Hence, wafer support jigs of this type are widely utilized in the CVD processes.

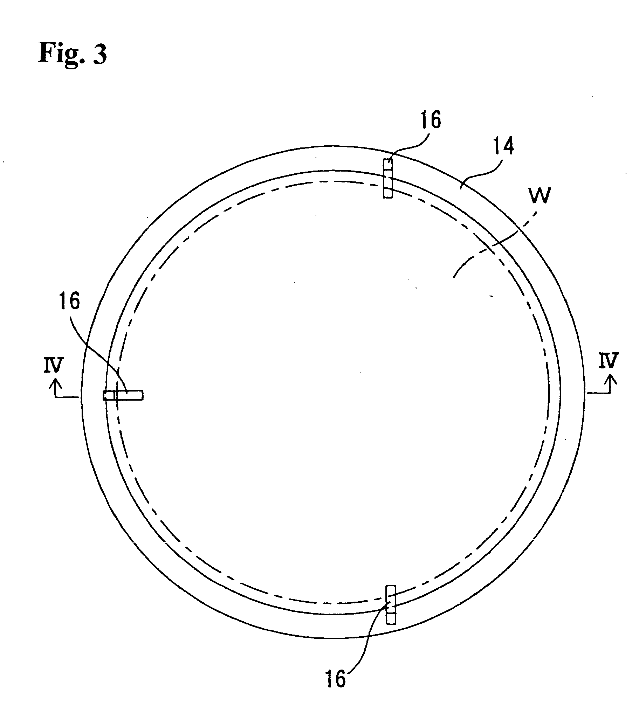

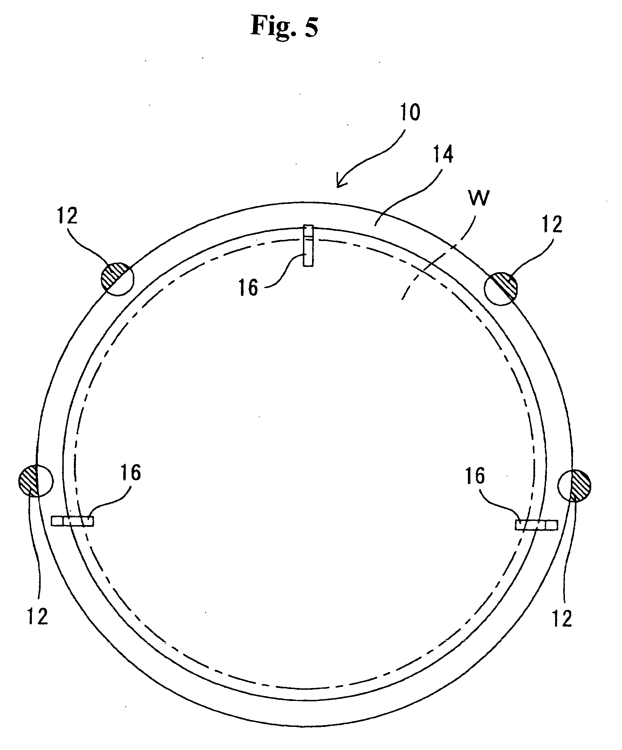

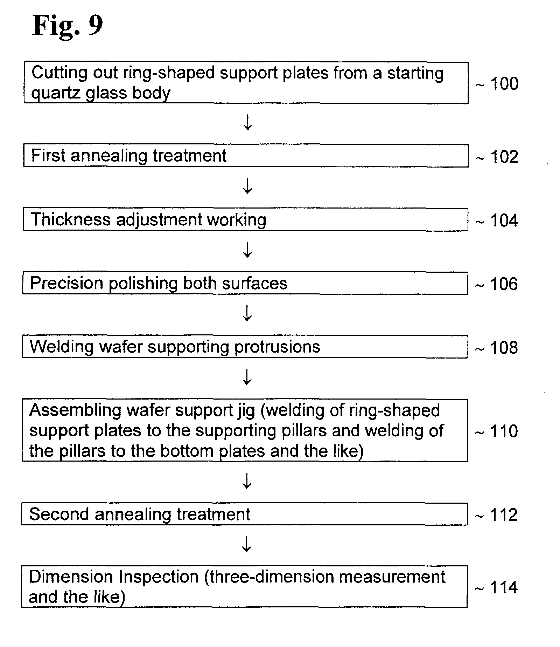

Referring to Figs. 3 to 6 and to Fig. 9, the wafer support jig of the second type of a conventional type is described below. In Fig. 5, a quartz glass wafer support jig 10 of the second type above comprises a plurality of ring-shaped support plates 14 that are attached to a plurality of pillars 12 (in the figure, 4 pillars) by means of welding.

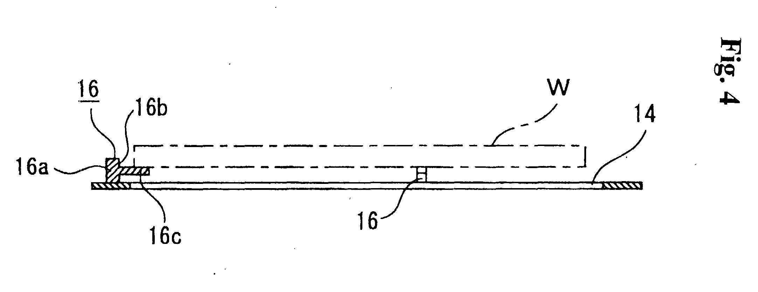

In the upper surface of the ring-shaped support plates 14, a plurality (in the figure, three) of wafer supporting protrusions 16 are provided by taking a proper distance from each other (see Figs. 3 and 5). The wafer supporting protrusions 16 are each constructed from a leg portion 16a installed on the upper surface of the ring-shaped support body 14 and a wafer support arm portion 16c provided with a stepped portion 16b, which is extended inward to the ring-shaped support body 14 from the upper portion of said leg portion 16a (see Fig. 4).

The wafer support jig 10 of a conventional type as described above is generally produced by a method as shown in Fig. 9. Firstly, ring-shaped support plates 14 are cut out in a ring-like shape by means of laser cutting and the like from a starting quartz glass body (Step 100). The ring-shaped support plates 14 thus cut out are subjected to annealing treatment with an aim to remove strain (Step 102). The ring-shaped support plates 14 are then processed to adjust the thickness thereof to a predetermined size (Step 104).

In order to smooth the surface of the ring-shaped support plates 14, the upper and the lower planes 14a and 14b are both subjected to precision polishing (Step 106). The precision polishing refers to a polishing that results in a surface roughness in the order of from about 0.05 to 0.1 mm, and the thickness adjustment process above is carried out as a pretreatment in order to reduce the irregularities and to thereby improve the dimensional precision. That is, the thickness of the entire ring-shaped support plate 14 is homogenized, and precision polishing is applied thereafter by using free abrasives and the like. In this manner, a ring-shaped support plate 14 finished to have a more uniform thickness and a smoother surface can be implemented. Free abrasives are favorably employed in the precision polishing above.

Then, a plurality of wafer supporting protrusions 16 are welded to the upper surface of said ring-shaped support plate 14 (Step 108). Finally, a plurality of the ring-shaped support plates 14 are welded superposed on the vertical direction to a plurality of supporting pillars 12 with a predetermined wafer mounting distance taken between the neighboring ring-shaped support plates 14. The support pillars are assembled with a top plate and a bottom plate to obtain the wafer support jig 10 (Step 110). The wafer support jig 10 thus obtained is then subjected to the annealing treatment to remove the strain mainly caused by welding and the like (Step 112). The finished wafer support jig 10 is subjected to a dimensional inspection by using a measuring machine (for instance, a three-dimension coordinate measuring apparatus) (Step 114).

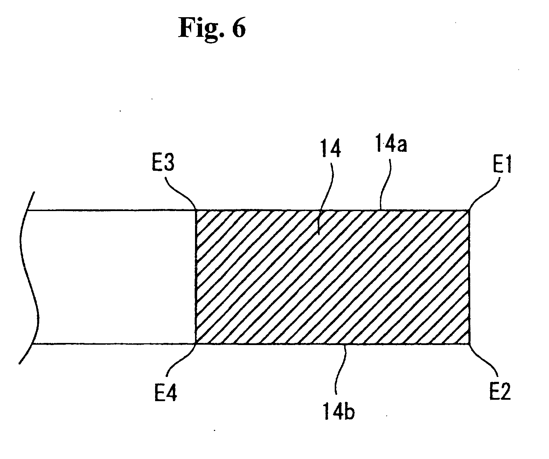

The ring-shaped support plates 14 of the wafer support jig 10 of a conventional type thus produced have the upper and the lower plates both precision polished. As a result, as shown in Fig. 6, the ring-shaped support plates 14 have been found unavoidable to have sharp acute edges for the outer and inner peripheries E1, E2, E3, and E4.

In the wafer heat treatment process, e.g., in the CVD process, during the production of semiconductors, on the other hand, the generation of particles should be suppressed as much as possible both in number and in size. With the recent demand for an increase in wafer diameter and for the implementation of finer circuits and the like, it is further required to reduce or suppress the generation of particles.

### The Problems the Invention is to Solve

However, the CVD process using a wafer support jig equipped with ring-shaped support plates described above have frequently met with the phenomena of generating particles.

In the light of such circumstances, the present inventors performed extensive studies to determine the reason of generating particles. As a result, they have found a relation between the shape of the ring-shaped support plates of the conventional type and the generation of particles, and have achieved the present invention.

An object of the present invention is to provide a novel wafer support jig and a process for producing the same, said wafer support jig capable of considerably suppressing the generation of particles in the wafer heat treatment process, e.g., a CVD process, in the production of semiconductors.

### Means for Solving the Problems

In order to overcome the problems above, a first embodiment of a quartz glass wafer support jig according to the present invention is characterized in that, the support plates each have its upper and lower surfaces precisely polished and provided with chamfered portions formed by chamfering the upper and lower edge portions of the outer and inner peripheries thereof.

Although differing depending on the thickness of the ring-shaped support plate, the chamfered width of the chamfered portions is preferably 0.3 mm or greater, and more preferably, 0.5 mm or greater. Further taking into consideration the degree of stress concentration and the like on forming a CVD film, it is further effective to provide the chamfered width of the chamfered portion of the chamfered portion for the upper and the lower edge portions of the inner periphery to be larger than the chamfered width of the upper and lower edge portions of the outer periphery.

According to a second embodiment of the quartz glass wafer support jig according to the present invention, the quartz glass wafer support jig is characterized in that said support plates each have its upper and lower surfaces precisely polished and are provided with curved portions formed by fire polishing the upper and lower edge portions of the outer and inner peripheries thereof.

A first embodiment of the method for producing a quartz glass wafer support jig of the present invention comprises the process steps (a) to (h) as follows:
(a) a step of cutting out ring-shaped support plates from a starting quartz glass body;
(b) a first annealing step comprising annealing said ring-shaped support plates thus cut out;
(c) a step of processing said ring-shaped support plates to adjust the thickness thereof;
(d) a step of precisely polishing the upper and the lower surfaces of said ring-shaped support plates;
(e) a step of chamfering the upper and lower edge portions of each of the outer and inner peripheries of said ring-shaped support plates;
(f) a step of welding a plurality of wafer supporting protrusions on the upper surface of said ring-shaped support plates;
(g) a step of assembling a wafer support jig by providing, to a plurality of supporting pillars, a plurality of said ring-shaped support plates superposed one after another in the vertical direction, with a predetermined distance for mounting the wafers taken between the neighboring two plates; and
(h) a second annealing step of annealing the thus formed wafer support jig.

A second embodiment of the method for producing a quartz glass wafer support jig of the present invention comprises the process steps (a) to (h) as follows:
(a) a step of cutting out ring-shaped support plates from a starting quartz glass body;
(b) a first annealing step comprising annealing said ring-shaped support plates thus cut out;
(c) a step of processing said ring-shaped support plates to adjust the thickness thereof;
(d) a step of precisely polishing the upper and the lower surfaces of said ring-shaped support plates;
(e) a step of applying fire polishing to the upper and lower edge portions of each of the outer and inner peripheries of said ring-shaped support plates;
(f) a step of welding a plurality of wafer supporting protrusions on the upper surface of said ring-shaped support plates;
(g) a step of assembling a wafer support jig by providing, to a plurality of supporting pillars, a plurality of said ring-shaped support plates superposed one after another in the vertical direction with a predetermined distance for mounting the wafers taken between the neighboring two plates; and
(h) a second annealing step of annealing the thus formed wafer support jig.

### Mode of Practicing the Invention

A mode for practicing the present invention is described below in accordance with the attached drawings. However, it should be understood that the specific examples, while indicating preferred embodiments of the invention, are given by way of illustration only, since various changes and modifications within the spirit and scope of the invention will become apparent to those skilled in the art from this detailed description.

Since the basic constitution of the quartz glass wafer support jig according to the present invention is the same as those shown in Figs. 3 to 5 illustrating the conventional constitution, a further explanation is omitted.

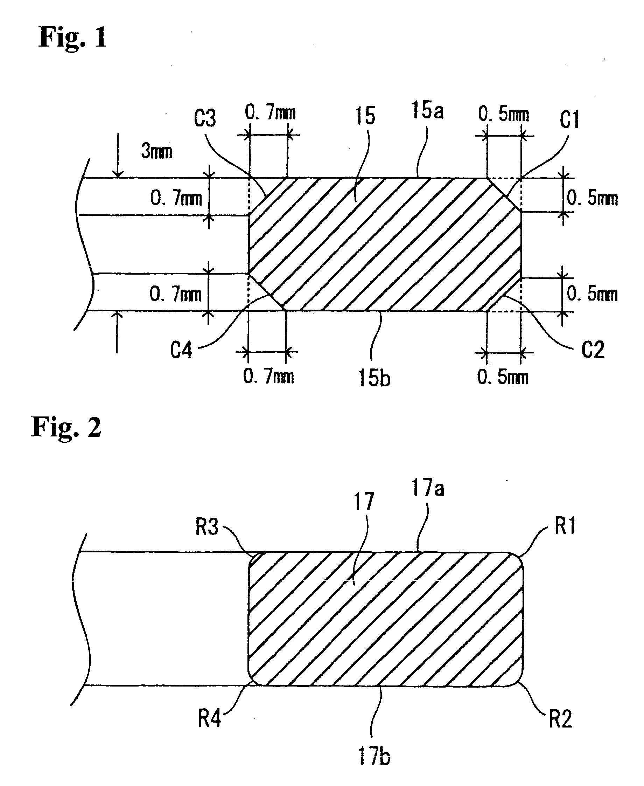

A first embodiment of the quartz glass wafer support jig of the present invention is characterized by that both of the upper and the lower planes 15a and 15b of the ring-shaped support plate 15 are precision polished, and that chamfered portions C1, C2, C3, and C4 are then formed by chamfering the upper and lower edge portions of the outer and inner peripheries of said ring-shaped support plate 15 (Fig. 1).

By forming the chamfered portions C1 to C4 above, the acute angle portions E1, E2, E3, and E4 (see Fig. 6) that were present in the upper and lower edge portions of the outer and inner peripheries of the ring-shaped support plate 14 of a conventional type can be eliminated. Thus, the particle generation attributed to the chipping and the like of the acute angle portions E1 to E4 can be eliminated, and the generation of particles from the quartz glass wafer support jig according to the first embodiment of the present invention can be greatly reduced.

In forming the chamfered portions C1 to C4 above, it is preferred that the chamfered width of the chamfered portions C3 and C4 for the upper and the lower edge portions of the inner periphery be set larger than that of the chamfered portions C1 and C2 for the upper and the lower edge portions of the outer periphery. For instance, in the case of a ring-shaped support plate 15 having a thickness of 3 mm, it is preferably designed so that the chamfered width of the chamfered portions C1 and C2 becomes 0.5 mm, while that of the chamfered portions C3 and C4 is 0.7 mm. Because it is believed that the particle generation is influenced by the state of gas flow in CVD process and the like, the constitution above is presumed effective to suppress the generation of particles.

Further, the second embodiment of the quartz glass wafer support jig according to the present invention is characterized in that the upper and the lower planes 17a and 17b of the ring-shaped support plate 17 are both precision polished, and that the upper and the lower edge portions of the outer and inner peripheries of the ring-shaped support plates 17 are fire polished to form curved portions R1, R2, R3, and R4 (see Fig. 2).

Similarly referring to Fig. 1, by thus forming curved portions R1 to R4 above, the acute angle portions E1, E2, E3, and E4 that were present in the upper and lower edge portions of the outer and inner peripheries of the ring-shaped support plate 14 of a conventional type can be eliminated. In this manner, the particle generation attributed to the "chipping" and the like (i.e., dropping, peeling off, etc.) of the acute angle portions E1 to E4 can be eliminated, and the generation of particles from the quartz glass wafer support jig according to the second embodiment of the present invention can be greatly reduced.

The reason why the particle generation can be greatly reduced by providing the chamfered portions C1 to C4 or the curved portions R1 to R4 to the edge portions of the ring-shaped support plate 14 above can be explained as follows. That is, in the case where a CVD film and the like is formed on the surface of a quartz glass ring-shaped support plate 14, chipping occurs on the acute angle portions E1 to E4 as to become the cause of particle generation. On the other hand, by providing the chamfered portions C1 to C4 or the curved portions R1 to R4 in the place of the acute angle portions E1 to E4, it is presumed that the stress concentration in case of forming a CVD film and the like can be relaxed, and that the chipping of the quartz glass can be decreased, thereby resulting in the reduction of the number and the size of the generating particles.

Subsequently, the method for producing a quartz glass wafer support jig according to the present invention is described. However, since most of the process steps of the present invention are the same as those described for a conventional process with reference to Fig. 9, the explanation is made on the specific process characteristic to the present invention while omitting that for the overlapping steps.

The process for producing a quartz glass wafer support jig according to a first embodiment of the present invention is characterized in that chamfering (Step 107) is applied to the upper and the lower edge portions of the outer and inner peripheries of the ring-shaped support plate 15 after performing precision polishing on the both surfaces of the ring-shaped support plate 15 (Step 106), and that a step of welding the wafer supporting protrusions (Step 108) is carried out thereafter. By performing the chamfering steps in the order above, the chamfering process can be smoothly accomplished.

The process for producing a quartz glass wafer support jig according to a second embodiment of the present invention is characterized in that fire polishing (Step 107a) is applied to the upper and the lower edge portions of the outer and inner peripheries of the ring-shaped support plate 17 after performing precision polishing on the both surfaces of the ring-shaped support plate 17 (Step 106), and that a step of welding the wafer supporting protrusions (Step 108) is carried out thereafter. By performing the fire polishing process steps in the order above, the chamfering process can be smoothly accomplished.

### Effect of the Invention

As described above, the quartz glass wafer support jig according to the present invention achieves a great effect of considerably suppressing the generation of particles in the wafer heat treatment process, for instance, in the CVD process, during the production process of semiconductors. Furthermore, a quartz glass wafer support jig according to the present invention can be efficiently produced.

### Brief Description of the Drawings

**Fig. 1** is an explanatory partial cross section diagram showing a ring-shaped
   support plate of a quartz glass wafer support jig according to an embodiment of the present invention.
**Fig. 2** is an explanatory partial cross section diagram showing a ring-shaped support plate of a quartz glass wafer support jig according to another embodiment of the present invention.
**Fig. 3** is a planar view of a ring-shaped support plate according to an example of a prior art quartz glass wafer support jig.
**Fig. 4** is a cross section view taken along line IV-IV shown in Fig. 3.
**Fig. 5** is a transverse cross section view of an example according to a prior art quartz glass wafer support jig.
**Fig. 6** is a partial cross section view of an example of a ring-shaped support plate according to a prior art quartz glass wafer support jig.

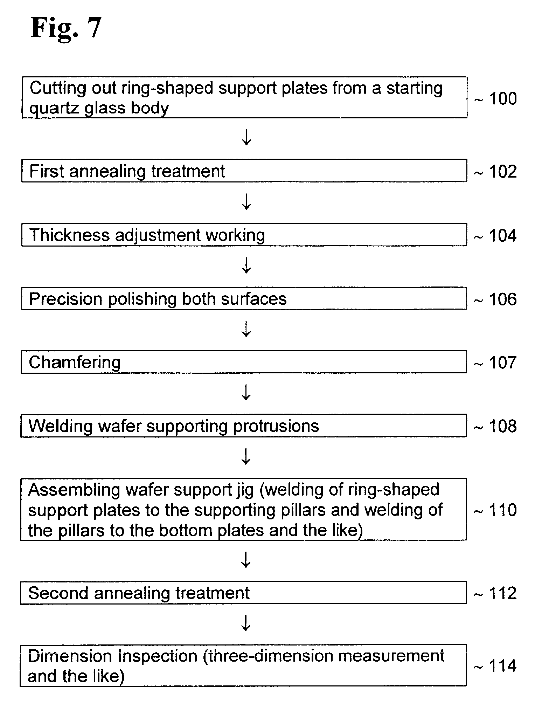

**Fig. 7** is a flow diagram showing an example of the process steps for producing a quartz glass wafer support jig according to the present invention.

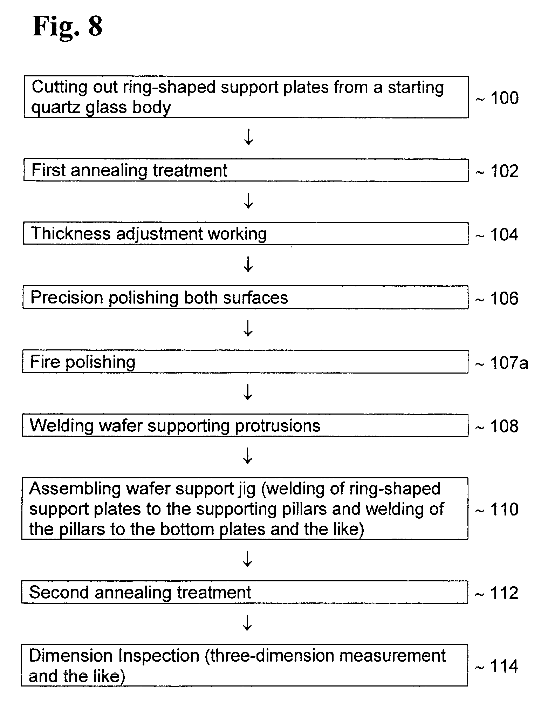

**Fig. 8** is a flow diagram showing another example of the process steps for producing a quartz glass wafer support jig according to the present invention.
**Fig. 9** is a flow diagram showing an example of prior art process steps for producing a quartz glass wafer support jig.

### Explanation of the Symbols

10: Wafer support jig,
12: Support pillar,
14: Ring-shaped support plates conventionally used in the art,
15, 17: Ring-shaped support plates according to the present invention,
16: Wafer supporting protrusions,
16a: Leg portion, 16b: Stepped portion, 16c: Wafer-supporting arm portion,
17a, 17b: Upper and lower surfaces,
C1, C2, C3, C4: Chamfered portions,
E1, E2, E3, E4: Acute angle portions,
R1, R2, R3, R4: Curved (R) portions.

## Claims

1. A support jig of quartz glass for supporting wafers, said jig comprising
a plurality of support pillars connected with a plurality of ring-shaped support plates for mounting the wafers thereon,
said support plates each having an upper and a lower surface and being superposed one after another with a predetermined distance in a vertical direction between neighboring plates,
the upper and lower surfaces of each of the support plates being polished, and the support plates having chamfered portions formed by chamfering at least one of upper and lower edge portions of at least one of outer and inner peripheries thereof.

2. A support jig as claimed in Claim 1, wherein the support plates have chamfered portions formed by chamfering the upper and lower edge portions of the outer and inner peripheries thereof.

3. A support jig as claimed in Claim 2, wherein the chamfered portions of the upper and lower edge portions of the inner periphery have a chamfered width that is larger than a chamfered width of the chambered portions of the upper and lower edge portions of the outer periphery.

4. A support jig of quartz glass for supporting wafers, said support jig comprising
a plurality of support pillars having connected therewith a plurality of ring-shaped support plates for mounting thereon the wafers,
said support plates each having an upper and a lower surface and being superposed one after another with a predetermined vertical distance between neighboring plates, and
said upper and lower surfaces of each of the support plates being polished and having curved portions formed by fire polishing upper and lower edge portions of outer and inner peripheries of the support plate.

5. A method for producing a support jig of quartz glass for supporting wafers, said method comprising:
(a) a step of cutting out ring-shaped support plates from a starting quartz glass body;
(b) a first annealing step comprising annealing said ring-shaped support plates thus cut out;
(c) a step of processing said ring-shaped support plates to adjust the thickness thereof;
(d) a step of polishing the upper and the lower surfaces of said ring-shaped support plates;
(e) a step of chamfering the upper and lower edge portions of each of the outer and inner peripheries of said ring-shaped support plates;
(f) a step of welding a plurality of wafer supporting protrusions on the upper surface of said ring-shaped support plates;
(g) a step of assembling the support jig by providing, to a plurality of supporting pillars, a plurality of said ring-shaped support plates superposed one after another in a vertical direction, with a predetermined distance for mounting the wafers taken between adjacent plates; and
(h) a second annealing step of annealing the thus formed support jig.

6. A method for producing a support jig of quartz glass for supporting wafers, said method comprising:
(a) a step of cutting out ring-shaped support plates from a starting quartz glass body;
(b) a first annealing step comprising annealing said ring-shaped support plates thus cut out;
(c) a step of processing said ring-shaped support plates to adjust the thickness thereof;
(d) a step of polishing upper and the lower surfaces of said ring-shaped support plates;
(e) a step of applying fire polishing to upper and lower edge portions of each of outer and inner peripheries of said ring-shaped support plates;
(f) a step of welding a plurality of wafer supporting protrusions on the upper surface of said ring-shaped support plates;
(g) a step of assembling said support jig by providing, to a plurality of supporting pillars, a plurality of said ring-shaped support plates superposed one after another in a vertical direction with a predetermined distance for mounting the wafers taken between adjacent plates; and
(h) a second annealing step of annealing the thus formed support jig.
